# EUROPÄISCHE PATENTANMELDUNG

(11) **EP 2 190 013 A2**
(43) Veröffentlichungstag der Anmeldung: **26.05.2010**
(21) Anmeldenummer: 09172888.1
(22) Anmeldetag: 13.10.2009
(51) Int. Cl.: H01L 23/49, B23K 35/02, B23K 35/365, C23C 14/56, C23C 16/54, C23C 28/00

(54) **Anschlussdraht und Verfahren zur Herstellung eines solchen**

(30) Priorität: 31.10.2008 DE 102008043361
(71) Anmelder: Micro Systems Engineering GmbH, 95180 Berg (DE); Technische Universität Dresden, 01062 Dresden (DE)
(72) Erfinder: Dohle, Rainer, 95119 Naila (DE); Rudolf, Frank, 01773 Altenberg (DE); Wenzel, Christian, 01705 Freital (DE)
(74) Vertreter: Lindner-Vogt, Karin L.

(57) **Zusammenfassung**

Die Erfindung betrifft einen Anschlussdraht mit einem elektrisch leitenden Kerndraht (10), mit einer auf der Oberfläche des Kerndrahts angeordneten Beschichtung (14), welche aus einer Tantal- oder Wolframlegierung besteht, die als zusätzliche Legierungsbestandteile Stickstoff und gegebenenfalls Silizium enthalten.

Weiterhin umfasst die Erfindung ein Herstellverfahren für einen erfindungsgemäßen Anschlussdraht.

## Beschreibung

Die Erfindung betrifft einen mit Ultraschall bondbaren Anschlussdraht, vorzugsweise in Form eines Runddrahtes mit einem kreisförmigen oder einem elliptischen Querschnitt oder in Form eines Bändchens vorzugsweise mit einem im Wesentlichen rechteckförmigen Querschnitt, mit einem elektrisch leitenden Kerndraht, vorzugsweise bestehend aus Gold und/oder einer Goldlegierung und/oder Kupfer und/oder einer Kupferlegierung, und einer auf der Oberfläche des Kerns angeordneten Beschichtung.

Ferner betrifft die Erfindung ein Verfahren zur Herstellung eines solchen Anschlussdrahts.

Anschlussdrähte dienen dazu, einen Halbleiterchip mit einem Substrat oder einem Verdrahtungsträger mechanisch und elektrisch zu verbinden. Diese elektrische Verbindung verbindet die Anschlussflächen des Halbleiterchips mit den auf dem Substrat / Verdrahtungsträger angeordneten Leiterbahnen. Deshalb werden als Materialien für Anschlussdrähte elektrisch gut leitende Materialien wie Gold, eine Goldlegierung, Kupfer oder eine Kupferlegierung verwendet.

Zum Befestigen und Verbinden von Anschlussdrähten an einem Substrat bzw. einem Halbleiterchip werden Bondverfahren eingesetzt.

Unter Bondverfahren (genauer: Drahtbondverfahren) werden in der Elektrotechnik Verbindungstechniken bezeichnet, bei denen eine Verbindung zwischen einem Chip und einem Verdrahtungsträger mit Hilfe eines dünnen Drahtes (Anschlussdraht) und durch Verschweißen des Drahts mit der Anschlussfläche erzeugt wird. Die Verschweißung kann beispielsweise mittels thermischer Aktivierung ("Thermosonicbonden") oder mittels Ultraschall ("Ultrasonicbonden"; "US-Bonden") erfolgen, wobei der Vorteil des Ultraschall gestützten Drahtbondens bei Verwendung von Aluminiumdraht darin besteht, dass eine Bondverbindung bei Raumtemperatur erzeugt werden kann. Hierdurch werden die elektronischen Elemente vor Überhitzung geschützt. Als weiterer Vorteil des US-Bondens bei Raumtemperatur ist zu nennen, dass man großvolumige und damit schwer zu erwärmende Bauteile nicht heizen muss und dadurch Fertigungszeit sowie Energie einspart.

Eine Weiterentwicklung solcher Drähte zur besseren Nutzung bei US-Bondverfahren sind beschichtete Anschlussdrähte. Dabei werden Kerndrähte aus gut leitendem Material beschichtet.

Beschichtete Anschlussdrähte und Bondverfahren dafür sind in mannigfaltiger Art und Weise bekannt. In DE 42 32 745 C2 wird ein Anschlussdraht beschrieben, der mittels Ultraschallbonden an einem Bauelement befestigt werden kann. Der bekannte Anschlussdraht weist einen Kern aus Gold oder Kupfer und eine auf diesem Kern aufgebrachte Beschichtung aus Aluminium oder Aluminiumoxid auf, wobei die Beschichtung eine mittlere Schichtdicke von 5 nm bis 100 nm hat. Der Anschlussdraht mit der bekannten Beschichtung ermöglicht eine sichere Bondverbindung bei Raumtemperatur, insbesondere beim Ultraschallbonden. Nachteilig ist gegenwärtig die gegenüber unbeschichtetem Draht verringerte Werkzeugstandzeit durch Ablagerungen am Bondwerkzeug, die vom Beschichtungsmaterial herrühren.

Dieselben Nachteile weist der aus der DE 10 2006 023 167 B3 bekannte Anschlussdraht auf, bei dem auf einem härteren Kern ein weicheres Material angeordnet ist. Auch hier sind Ablagerungen des Beschichtungsmaterials auf dem Werkzeug festzustellen, die zu verringerter Werkzeugstandzeit und/oder zu Ungenauigkeiten beim Bondverfahren führen.

Aus DE 102 61 436 A1 ist ein Halbleiter-Bauelement mit einer Bondinsel und einem Anschluss bekannt, welcher über einen beschichteten Kupfer-Anschlussdraht mit der Halbleiterchip-Bondinsel verbunden ist. Die Beschichtung ist eine Oxidationsschutzschicht, welche aus Palladium oder Platin gebildet ist.

Diese bekannte technische Lösung kann nur beim sogenannten "Ballbondverfahren" verwendet werden, bei dem das Drahtende vor einem Bondvorgang aufgeschmolzen wird, so dass sich ein Tropfen bildet, der besser bondbar ist. Dazu muss eine Oxidation der Oberfläche vermieden werden.

Ebenfalls nur mit einem Ball- oder Wedgebondverfahren verwendbarer Bondraht ist neben seiner Herstellung und Verwendung aus der DE 10 2005 011028 A1 bekannt. Dort wird ein Kupfer-Anschlussdraht offenbart, bei dem in der Oberfläche Gold angereichert ist.

Ausgehend von diesem Stand der Technik besteht der Wunsch und die Aufgabe, einen Anschlussdraht zu schaffen, der einerseits eine hohe Sicherheit und Zuverlässigkeit beim Ultraschallbonden ermöglicht und andererseits eine kostengünstige und störungsfreie Produktion von elektronischen Bauelementen und -gruppen ermöglicht. Weiterhin besteht der Bedarf und die Aufgabe nach leicht und zuverlässig bondbaren Anschlussdrähten, die in ihrer Funktionalität als mechanische und elektrische Verbindung nicht oder höchstens sehr gering eingeschränkt sind.

Diese Aufgabe wird durch den Gegenstand des unabhängigen Anspruchs 1 gelöst, indem ein Anschlussdraht mit einem elektrisch leitenden Kern, der als Kerndraht oder Kernbändchen ausgebildet ist, eine auf der Oberfläche des Kerns angeordneten Beschichtung aufweist, welche aus einer Tantal- oder Wolframlegierung besteht, die als zusätzliche Legierungsbestandteile Stickstoff und gegebenenfalls Silizium enthalten. Bevorzugt besteht die Beschichtung aus einer Tantal-Stickstoff-Legierung (TaN) oder einer Tantal-Silizium-Stickstoff-Legierung (TaSiN) oder einer Wolfram-Silizium-Stickstoff-Legierung (WSiN). Besonders bevorzugt besteht die Legierung aus Tantal, Silizium und Stickstoff in einem atomaren Verhältnis von 58:16:26 (Ta₅₈Si₁₆N₂₆). Vorteilhafterweise ist die Beschichtung aus der Tantal- oder Wolframlegierung härter relativ zum Kern. Dadurch werden Verunreinigungen vermieden, die Werkzeugstandzeit erhöht und die Herstellung kostengünstiger gestaltet.

Die Beschichtung aus der Tantal- bzw. Wolframlegierung weist dabei bevorzugt eine Dicke von 2 nm bis 100 nm, besonders bevorzugt von 5 nm bis 50 nm, auf. Dies bewirkt, dass die Störeinflüsse der Beschichtung auf die Leitfähigkeit des Anschlussdrahtes minimiert sind bzw. soweit akzeptabel sind, dass eine störungsfreie Funktion sowie eine hohe Langzeitzuverlässigkeit der mit dem Bonddraht hergestellten Bauelemente bzw. Baugruppen ermöglicht wird.

Die bondfähige Schicht des Anschlussdrahtes weist im Bereich ihrer Oberfläche und einer dünnen Schicht direkt unter der Oberfläche eine Oxidschicht mit den Elementen Silizium und/oder Tantal auf. Als überraschender Effekt treten bei Verwendung dieses Schichtsystems weniger Materialablagerungen (Build-Up), das heißt weniger Anlagerung von Drahtmaterial am Bondwerkzeug. Damit wird die Standzeit des Bondwerkzeugs deutlich vergrößert.

Die Oberfläche wird demnach als Außenoberfläche definiert, also die Oberfläche der Beschichtung, die dem Kern abgewandt ist. Der Bereich der Oberfläche umfasst demnach auch einen in Richtung des Kerns weisenden Abschnitt, der eine Dicke von wenigen Atomlagen aufweist, vorzugsweise eine Dicke von circa 2 bis 200 Atomlagen.

In einer weiteren bevorzugten Ausführung ist auf der dem Kern gegenüberliegenden Fläche der Beschichtung eine Aluminium enthaltende bondfähige Schicht angeordnet. Dadurch wird eine sichere und zuverlässige Bondverbindung bei einer Temperatur unterhalb von 120°C oder sogar bei Raumtemperatur erreicht. Weiter bevorzugt weist diese bondfähige Schicht im Bereich ihrer Oberfläche eine dichte Schicht aus Aluminiumoxid (Al₂O₃) auf. Diese Schicht ist unschädlich und beeinflusst die Bondfähigkeit sogar in vorteilhafter Weise, da sie wie Schmirgelpapier wirkt und hierdurch eine feste Bondverbindung mit dem Bondpartner sogar bei Raumtemperatur erzeugt, indem oberflächliche, nur wenige Atomlagen dicke Schichten, beispielsweise aus natürlichen Kontaminationen wie Kohlenstoffverbindungen, Wasser oder andere, bei Raumtemperatur stets vorhandene Kontaminationsschichten, auf der Bondinsel abgetragen werden. Das Bonden unterhalb von 120°C oder bei Raumtemperatur wird also weiter erleichtert. Dadurch wird die störungsfreie Herstellung von mechanischen und elektrischen Verbindungen mit Anschlussdrähten ermöglicht.

Die Oberfläche der bondfähigen Schicht wird demnach als Außenoberfläche definiert, also die Oberfläche, die von der Tantal- oder Wolframbeschichtung abgewandt ist und an der das Bondverfahren durchgeführt wird und eine Verbindung mit einer Bondinsel hergestellt wird. Der Bereich der Oberfläche umfasst demnach auch einen in Richtung des Kerns weisenden Abschnitt, der eine Dicke von wenigen Atomlagen aufweist, vorzugsweise eine Dicke von circa 2 bis 200 Atomlagen.

Bevorzugt weist die bondfähige Aluminiumschicht der bevorzugten Ausführung eine Schichtdicke zwischen 2,5 nm und 50 nm, bevorzugt zwischen etwa 6 nm und 40 nm und besonders bevorzugt zwischen etwa 7 nm und 35 nm auf. Eine limitierte Schichtdicke der Aluminiumbeschichtung beeinflusst vorteilhaft die Werkzeugstandzeit bei der Produktion. Die Verunreinigung des Bondwerkzeuges kann bei minimaler Schichtdicke des relativ weichen Aluminiums so gering gehalten werden, dass die Austauschintervalle der Werkzeuge stark verlängert werden können. Dadurch wird die Auslastung der Bond-Automaten und damit die Kosteneffizienz erhöht.

Weiter bevorzugt kann auch vorgesehen werden, dass die Schichtdicke der genannten Beschichtungen vom Drahtdurchmesser bzw. von der Dicke des Kerndrahtes bzw. des Kernbändchens abhängig ist. So weist die Beschichtung aus der Tantal- oder Wolframlegierung eine Schichtdicke im Bereich von ungefähr 0,05% des Kerndrahtdurchmessers und/oder die bondfähige Schicht eine Schichtdicke im Bereich von ungefähr 0,025% des Kerndrahtdurchmessers auf. Alternativ weißt die Beschichtung aus der Tantal- oder Wolframlegierung eine Schichtdicke von ungefähr 0,05% der Dicke des Kernbändchens und/oder die bondfähige Schicht eine Schichtdicke von ungefähr 0,025% der Dicke des Kernbändchens auf. Dies verbessert weiter die störungsfreie Funktion des Anschlussbandes oder Anschlussdrahtes als mechanische und elektrische Verbindung.

Ein derartiger Anschlussdraht ermöglicht die gewünschte sichere und zuverlässige Bondverbindung auf der einen Seite und auf der anderen Seite gleichzeitig eine hohe Werkzeugstandzeit. Hierbei ist die Bondverbindung so zuverlässig, dass die Substrate / Verdrahtungsträger unterhalb einer Temperatur von 120°C oder sogar bei Raumtemperatur sicher gebondet werden können. Dies bedeutet, dass auch temperaturempfindliche Substrate mit dem erfindungsgemäßen Anschlussdraht gebondet werden können und nicht beheizt werden müssen. Außer Siliziumhalbleitern können zudem temperaturempfindliche halbleitende Materialien, zum Beispiel bei optoelektronischen Bauelementen wie Halbleiterlasern auf der Basis von GaA- oder InP-Lasern, zuverlässig gebondet werden. I

Ein weiterer Vorteil ist die längere Lagerfähigkeit der erfindungsgemäßen Drähte gegenüber Drähten, die dem Stand der Technik entsprechen.

Außerdem können günstigere HF- und Mikrowelleneigenschaften der mit den erfindungsgemäßen Anschlussdrähten verbundenen Bauelemente realisiert werden.

Die Aufgabe im Hinblick auf das Herstellverfahren für den Anschlussdraht gemäß Anspruch 1 besteht darin, dieses einfach und kostengünstig zu gestalten, wobei eine große Meterzahl von derartigen Anschlussdrähten in kurzer Zeit hergestellt werden soll.

Diese Aufgabe wird mit Anspruch 8 mit durch Herstellverfahren mit den folgenden Schritten gelöst:
- Abziehen des Kernmaterials in Form eines Drahtes von einer Abspulrolle, und
- Beschichten des Kerndrahtes durch Vorbeiführen desselben an einer ersten Beschichtungsquelle einer Beschichtungseinrichtung zur Erzeugung der Beschichtung aus einer Tantal- oder Wolframlegierung.

Optional kann der abgezogene Draht unmittelbar vor dem Beschichtungsprozess gereinigt werden, vorzugsweise mit einer in situ ionenphysikalischen Reinigung ohne Vakuumunterbrechung.

Vorzugsweise umfasst das Verfahren einen dem genannte (ersten) Beschichtungsschritt folgenden zweiten Beschichtungsschritt, bei dem durch Vorbeiführen des Kerndrahtes mit Beschichtung aus Tantal- oder Wolframlegierung an einer zweiten Beschichtungsquelle der Beschichtungseinrichtung eine bondfähige Schicht, vorzugsweise aus Aluminium, erzeugt wird.

Dabei ist die Beschichtungseinrichtung als eine CVD- oder eine PVD-Einrichtung ausgebildet, wobei besonders bevorzugt die bondfähige Schicht vakuumtechnisch beispielsweise durch Sputtern aufgebracht wird. Besonders bevorzugt werden röhrenförmige oder ringförmige Sputtertargets, oder Sputtertargets in Form eines Vierkantprofils eingesetzt.

Die Beschichtungseinrichtung kann in einer besonderen für die Herstellung bevorzugten Art zweigeteilt sein oder verwendet zwei getrennte Beschichtungseinrichtungen. In diesem Fall kann die Beschichtungseinrichtung als eine CVD- und eine PVD-Einrichtung ausgebildet, das heißt, die zwei getrennten Beschichtungseinrichtungen können mit verschiedenen Beschichtungstechniken arbeiten.

Im Anschluss an einen oder beiden der vorgenannten Beschichtungsschritte kann der Anschlussdraht gegebenenfalls wieder auf eine Aufspulrolle aufgespult werden, auf der der Anschlussdraht anschließend vertrieben werden kann. Bevorzugt nach dem zweiten Beschichtungsschritt kann sich ein weiterer Prozeß anschließen, indem der aluminiumbeschichtete Anschlussdraht gezielt mit Sauerstoff behandelt wird, um eine wohldefinierte Aluminiumoxidschicht zu erhalten. Im Anschluß an diesen Schritt kann der Anschlussdraht aufgespult und gegebenenfalls vakuumverpackt werden.

Vorzugsweise wird nach dem ersten und/oder nach dem zweiten Beschichtungsschritt ein Temperschritt durchgeführt. Dies verhindert, dass sich nach der oder den Beschichtung(en) die Härte des Anschlussdrahtes verändert.

Ein derartiges Verfahren ist einfach und kostengünstig, weil die Prozesse durch wenige Schritte unaufwendig gestaltet sind. Durch das Abrollen direkt von einer Abrollspule ermöglicht es die Herstellung einer großen Meterzahl von Anschlussdrähten in einer kurzen Zeit und kann leicht an die Parameter der Beschichtung angepasst werden. Die Beschichtungsdauer korreliert dabei beispielsweise mit der gewünschten Schichtdicke der bondfähigen Beschichtung.

Weitere Ziele, Merkmale, Vorteile und Anwendungsmöglichkeiten der Erfindung ergeben sich aus der nachfolgenden Beschreibung von Ausführungsbeispielen eines Anschlussdrahts gemäß Anspruch 1 bis 7 und eines erfindungsgemäßen Verfahrens zur Herstellung eines Anschlussdrahts gemäß Anspruch 8 bis 14 anhand der Figuren. Dabei bilden alle beschriebenen und/oder bildlich dargestellten Merkmale für sich oder in beliebiger Kombination den Gegenstand der vorliegenden Erfindung, unabhängig von ihrer Zusammenfassung in den einzelnen Ansprüchen oder deren Rückbeziehungen.

Des Weiteren wird ein Ausführungsbeispiel mit einem Kern aus einem runden Draht beschrieben. Es zeigen:

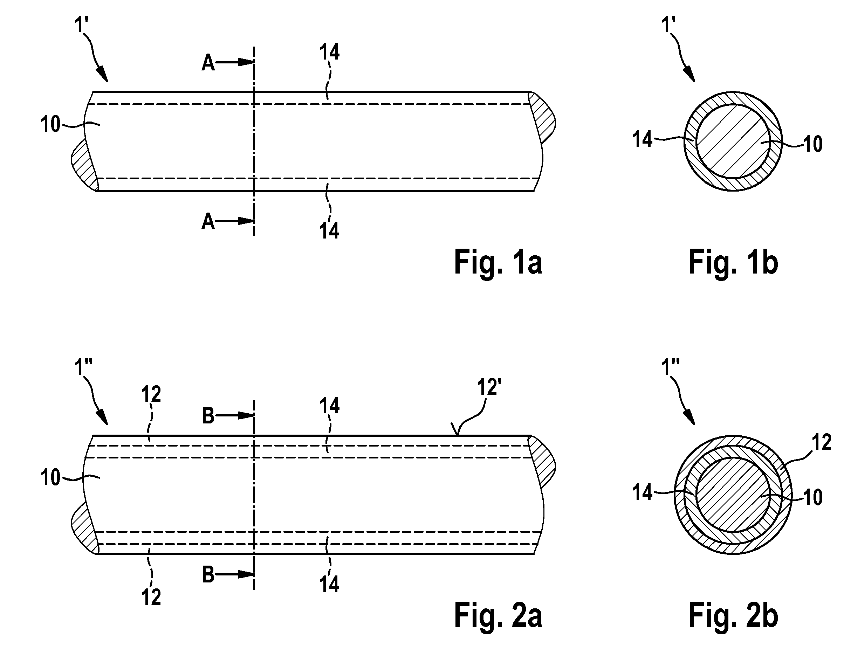

- Fig. 1a: einen Anschlussdraht gemäß einer ersten Ausführung mit einer Oberflächen- schicht aus TaSiN oder TaN,
- Fig. 1 b: einen Schnitt durch einen Anschlussdraht gemäß der ersten Ausführung entlang der Schnittlinie A aus Fig. 1a,
- Fig. 2a: einen Anschlussdraht gemäß einer zweiten Ausführung mit einer Zwischen- schicht aus TaSiN oder TaN und einer Oberflächenschicht aus oberflächlich oxi- diertem Aluminium
- Fig. 2b: einen Schnitt durch einen Anschlussdraht gemäß einer der zweiten Ausführung entlang der Schnittlinie B aus Fig. 2a
- Fig. 3: eine Vorrichtung zur Herstellung eines erfindungsgemäßen Anschlussdrahts ge- mäß Fig. 2a und 2b zur Erläuterung des Herstellverfahrens

Fig. 1a und 1b zeigen einen Anschlussdraht 1' gemäß einer ersten Ausführung. Der Kerndraht 10 besteht zumindest überwiegend aus relativ weichem, aber gut leitendem Gold und/oder einer Goldlegierung und/oder Kupfer und/oder einer Kupferlegierung, während die Beschichtung 12 aus einer Tantal- oder Wolframlegierung besteht, welche als zusätzliche Legierungsbestandteile Stickstoff und gegebenenfalls Silizium enthält.

Fig. 2a und 2b zeigen einen Anschlussdraht 1" gemäß einer zweiten Ausführung mit einem Kerndraht 10, überwiegend aus relativ weichem, aber gut leitendem Gold und/oder einer Goldlegierung und/oder Kupfer und/oder einer Kupferlegierung, der eine dünne Beschichtung 14 aufweist. Die Beschichtung 14 ist als Zwischenschicht ausgelegt und besteht aus einer Tantal- oder Wolframlegierung, welche als zusätzliche Legierungsbestandteile Stickstoff und gegebenenfalls Silizium enthält. Auf der dem Kerndraht 10 gegenüberliegenden Oberfläche der Beschichtung 14 weist der Anschlussdraht 1" eine bondfähige Beschichtung 12 auf, welche Aluminium enthält. Die Beschichtung 12 kann an der Oberfläche oder im Bereich der Oberfläche eine Aluminiumoxidschicht 12' aufweisen. Diese Schicht 12' kann dabei eine Dicke von wenigen Atomlagen haben.

Generell weist die Beschichtung 14 eine Dicke zwischen 2 nm bis 100 nm, bevorzugt 5 nm bis 50 nm auf. Die bondfähige Beschichtung 12 weist eine Schichtdicke zwischen 2,5 nm und 50 nm, bevorzugt zwischen etwa 6 nm und 40 nm und besonders bevorzugt zwischen etwa 7 nm und 35 nm auf. Denkbar ist auch, dass die Schichtdicke der Beschichtung und der bondfähigen Schicht von der Dicke bzw. dem Drahtdurchmesser des Kerndrahtes abhängig ist.

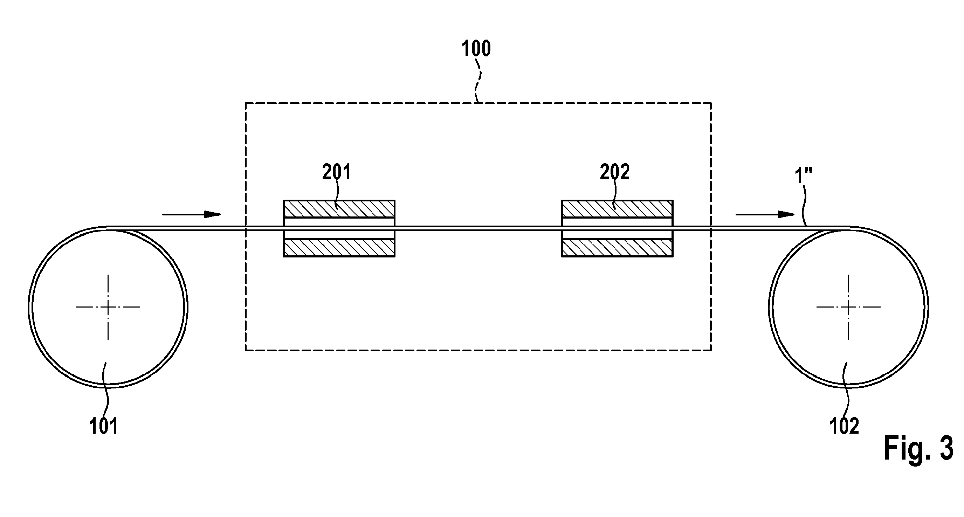

Fig. 3 zeigt eine Beschichtungseinrichtung 100 zur Beschichtung eines Anschlussdrahts 1" gemäß Fig. 2a und 2b zur Erläuterung des Herstellverfahrens. Das Material des Kerns in Form eines Drahtes 10 wird von einer Abspulrolle 101 abgezogen und gegebenenfalls am Ende des Herstellverfahrens auf eine Aufspulrolle 102 aufgewickelt. Dabei bewegt sich der Draht 10 in Pfeilrichtung, wie in Fig. 3 bezeichnet.

In einem ersten Schritt wird der Draht 10 durch ein erstes, rohrförmiges Sputtertarget 201 geführt, in dem die Beschichtung 14 aufgetragen wird. Anschließend wird der mit der Beschichtung 14 versehene Draht durch ein weiteres zweites, ebenfalls rohrförmiges, Sputtertarget 202 geführt, um die bondfähige Schicht 12 aufzutragen.

Hinter dem Sputtertarget 202 und im Herstellverfahren nach dem zweiten Beschichtungsschritt kann sich entweder innerhalb oder außerhalb der Beschichtungseinrichtung 100 und vor dem Aufrollen des Anschlussdrahtes auf die Aufspulrolle 102 eine Tempereinrichtung angeordnet sein, die zur Durchführung eines Temperschritts nach der Beschichtung des Drahts dient. Ein derartiger Temperschritt dient zur Härtebehandlung des Anschlussdrahtes. Eine weitere Tempereinrichtung kann sich zwischen den Sputtertargets 201 und 202 befinden.

Zwischen der Abspulrolle 101 und der Beschichtungseinrichtung kann eine Drahtreinigung in einem Vakuumprozess erfolgen.

Die erfindungsgemäßen Anschlussdrähte sind sowohl mittels Ultraschall bei Temperaturen kleiner als 120°C oder sogar bei Raumtemperatur bondbar und ermöglichen eine verbesserte Toolstandzeit des Bondtools.

### Bezugszeichenliste:

- 1': Anschlussdraht gemäß einer ersten Ausführung
- 1'': Anschlussdraht gemäß einer zweiten Ausführung
- 10: Kern des Anschlussdrahts 1', 1''
- 12: bondfähige Beschichtung
- 14: Beschichtung aus einer Tantal- oder Nickellegierung
- 100: Beschichtungseinrichtung
- 101: Abspulrolle
- 102: Aufspulrolle
- 201: Sputtertarget 1
- 202: Sputtertarget 2

## Patentansprüche

1. Anschlussdraht (1', 1'') mit einem elektrisch leitenden Kern (10) und einer auf der Oberfläche des Kerns angeordneten Beschichtung (14), **dadurch gekennzeichnet, dass** die Beschichtung aus einer Tantal- oder Wolframlegierung besteht, welche als zusätzliche Legierungsbestandteile Stickstoff und gegebenenfalls Silizium enthalten.

2. Anschlussdraht nach Anspruch 1, **dadurch gekennzeichnet, dass** die Beschichtung (14) nach Anspruch 1 aus TaSiN oder WSiN, vorzugsweise aus Ta₅₈Si₁₆N₂₆ besteht.

3. Anschlussdraht nach einem der vorhergehenden Ansprüche, **dadurch gekennzeichnet, dass** die Beschichtung (14) eine Schichtdicke von 2 nm bis 100 nm, bevorzugt 5 nm bis 50 nm aufweist.

4. Anschlussdraht nach einem der vorhergehenden Ansprüche 1 bis 3, **dadurch gekennzeichnet, dass** auf der dem Kerndraht (10) gegenüberliegenden Fläche der Beschichtung (14) eine Aluminium enthaltende bondfähige Schicht (12) angeordnet ist.

5. Anschlussdraht nach Anspruch 4, **dadurch gekennzeichnet, dass** die bondfähige Schicht (12) eine Schichtdicke zwischen 2,5 nm und 50 nm, bevorzugt zwischen etwa 6 nm und 40 nm und besonders bevorzugt zwischen etwa 7 nm und 35 nm aufweist.

6. Anschlussdraht (1', 1'') nach Anspruch 1, **dadurch gekennzeichnet, dass** der Kern aus einem Draht oder einem Bändchen gebildet ist.

7. Anschlussdraht nach Anspruch 6, **dadurch gekennzeichnet, dass** die Beschichtung (14) eine Schichtdicke von ungefähr 0,05% des Kerndrahtdurchmessers und/oder die bondfähige Schicht (12) eine Schichtdicke von ungefähr 0,025% des Durchmessers des Kerndrahts (10) aufweist, oder die Beschichtung (14) eine Schichtdicke von ungefähr 0,05% der Dicke des Kernbändchens und/oder die bondfähige Schicht (12) eine Schichtdicke von ungefähr 0,025% der Dicke des Kernbändchens aufweist.

8. Anschlussdraht nach einem der Ansprüche 4 oder 5, **dadurch gekennzeichnet, dass** die bondfähige Schicht (12) im Bereich ihrer Oberfläche eine Aluminiumoxidschicht (12') aufweist.

9. Verfahren zur Herstellung eines Anschlussdrahts (1', 1'') nach einem der Ansprüche 1 bis 8, welches die folgenden Schritte umfasst:
- Abziehen des Kernmaterials in Form eines Drahtes (10) von einer Abspulrolle (101), und
- einem Beschichtungsschritt durch Vorbeiführen des Kerndrahts an einer ersten Beschichtungsquelle (201) einer Beschichtungseinrichtung zur Erzeugung der Beschichtung aus einer Tantal- oder Wolframlegierung.

10. Verfahren nach Anspruch 9 zur Herstellung eines Anschlussdrahtes (1 ") nach einem der Ansprüche 4 bis 7, welches einen dem Beschichtungsschritt folgenden zweiten Beschichtungsschritt durch Vorbeiführen des Kerndrahts mit Beschichtung an einer zweiten Beschichtungsquelle (202) einer Beschichtungseinrichtung zur Erzeugung der bondfähigen Schicht umfasst.

11. Verfahren nach einem der Ansprüche 9 oder 10, **dadurch gekennzeichnet, dass** die Beschichtungseinrichtung (100) als eine CVD- und/oder eine PVD-Einrichtung ausgebildet ist.

12. Verfahren nach Anspruch 11, **dadurch gekennzeichnet, daß** röhrenförmige oder ringförmige Sputtertargets oder Sputtertargets mit der Form eines Vierkantprofils eingesetzt werden, durch welches der Bonddraht bzw. das Bändchen hindurchgeführt wird.

13. Verfahren nach Anspruch 9, **dadurch gekennzeichnet, daß** vor dem Beschichtungsschritt eine Vakuumreinigung des Kerndrahtes, vorzugsweise mit einer in situ ionenphysikalischen Reinigung ohne Vakuumunterbrechung, erfolgt.

14. Verfahren nach einem der Ansprüche 9 bis 13, **dadurch gekennzeichnet, dass** nach dem ersten und/oder nach dem zweiten Beschichtungsschritt ein Temperschritt durchgeführt wird.

15. Verfahren nach einem der Ansprüche 9 bis 14, **dadurch gekennzeichnet, daß** die Beschichtungseinrichtung (100) zweigeteilt ist oder zwei getrennte Beschichtungseinrichtungen verwendet werden.
